# EUROPEAN PATENT APPLICATION

(11) **EP 1 962 231 A2**
(43) Date of publication of application: **27.08.2008**
(21) Application number: 07124166.5
(22) Date of filing: 28.12.2007
(51) Int. Cl.: G06K 19/077

(54) **Production method of electronic apparatus, production method of electronic equipment in which electronic apparatus is packaged, and production method of article in which electronic apparatus is mounted**

(30) Priority: 23.02.2007 JP 2007043183
(71) Applicant: Fujitsu Ltd., Kawasaki-shi, Kanagawa 211-8588 (JP)
(72) Inventor: Kobayashi, Hiroshi Fujitsu Limited, Kawasaki-shi, Kanagawa 211-8588 (JP); Kobae, Kenji Fujitsu Limited, Kawasaki-shi, Kanagawa 211-8588 (JP); Takeuchi, Shuichi Fujitsu Limited, Kawasaki-shi, Kanagawa 211-8588 (JP)
(74) Representative: Wilding, Frances Ward

(57) **Abstract**

A production method of an electronic apparatus includes: a step of making a thermosetting adhesive (13p) adhere to a face of a base where an antenna pattern (112) is formed on a film made (111) of a resin material, the face being a face which the antenna pattern is formed on; a step of mounting a circuit chip (12) connected to the antenna pattern, on the base through the thermosetting adhesive; a preheating step of heating the thermosetting adhesive on a first heating condition by which the thermosetting adhesive becomes a first cured state; and a main heating step of fixing the circuit chip to the antenna pattern by heating and curing the thermosetting adhesive on a second heating condition by which the thermosetting adhesive becomes a second cured state harder than the first cured state, with the base being clamped and pressurized from both of the circuit chip side and the film side.

## Description

### BACKGROUND OF THE INVENTION

### Field of the Invention

The present invention relates to a production method of an electronic apparatus, a production method of electronic equipment in which the electronic apparatus is packaged, and a production method of an article in which the electronic apparatus is mounted, and in particular, relates to a production method of an electronic apparatus in which a circuit chip is mounted on a film-shaped base, a production method of equipment in which this electronic apparatus is packaged, and a production method of an article in which this electronic apparatus is mounted.

### Description of the Related Art

Conventionally, electronic apparatuses in each of which a circuit chip is mounted on a base, such as a printed-circuit board, are known widely. Such an electronic apparatus is embedded in electronic equipment to be used for controlling this electronic equipment or is used separately for exchanging information with external equipment. As an example of the electronic apparatus, various RFID (Radio_Frequency_IDentfication) tags contactlessly exchanging information with external equipment, represented by a reader writer, via radio waves are known. As a kind of these RFID tags, one having construction of mounting a conductor pattern and an IC chip for radio wave communication on a base sheet is proposed. Conceivable applications of such type of RFID tag include attaching the RFID tag to an article and the like and identifying the article by exchanging information regarding the article with external equipment.

An RFID tag is requested for miniaturization and weight reduction, in particular, thinning and flexibility, and low cost. Accordingly, an RFID tag adopting a film made of a resin material, such as polyethylene terephthalate (PET) and the like as a material of the base on which the IC chip is mounted is proposed. (For example, refer to Japanese Patent Application Publication No. 2001-156110.)

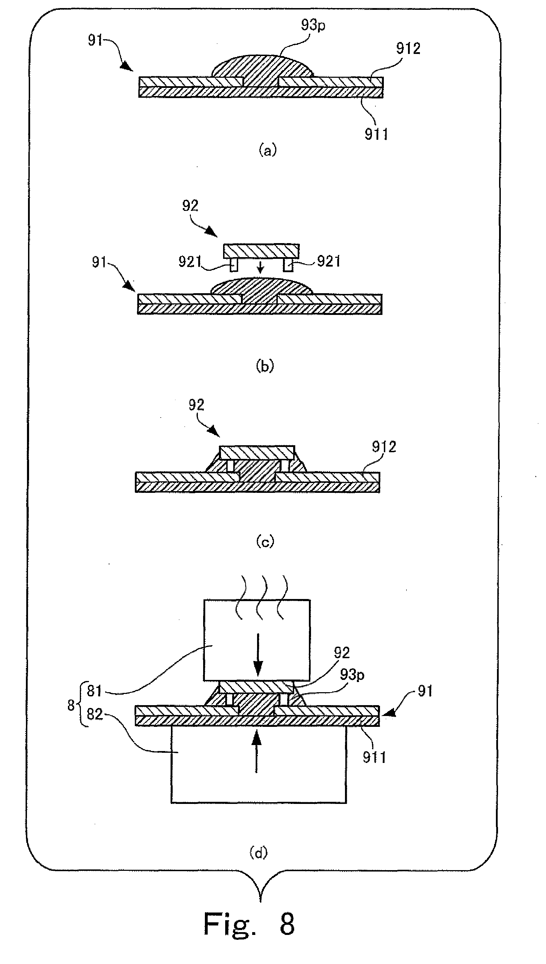

Fig. 8 is an explanatory diagram of a method of producing an RFID tag in a conventional technique.

Fig. 8 illustrates each step of producing an RFID tag in order from Part (a) to Part (d).

For producing an RFID tag, first, as illustrated in Part (a) of Fig. 8, a base 91 is prepared in which a conductor pattern 912, which functions as an antenna of the RFID tag, is formed on a film 911 made from PET. A thermosetting adhesive 93p, cured by heating, is made to adhere to this base 91.

Next, as illustrated in Part (b) of Fig. 8, an IC chip 92 is mounted on a portion of the base 91 which the thermosetting adhesive 93p adheres to. Bumps 921 to be connected to the conductor pattern 912 are formed on the IC chip 92. As illustrated in Part (c) of Fig. 8, the IC chip 92 is mounted on the base 91 so that positions of the bumps 921 coincide with the position of the conductor pattern 912.

Subsequently, as illustrated in Part (d) of Fig. 8, the base 91 on which the IC chip 92 is mounted is clamped by a heating apparatus 8 while being pressed from both of the film 911 side and the IC chip 92 side. Next, a heating head 81 of the heating apparatus 8 that abuts the IC chip 92 side heats and cures the thermosetting adhesive 93p. In this way, the IC chip 92 is fixed to the base 91 with the bumps 921 contacting the conductor pattern 912 and the small lightweight RFID tag is complete.

However, since PET which is a material of the film 911 has low heatproof temperature, it is easily deformed with heating at the time of curing the thermosetting adhesive 93p.

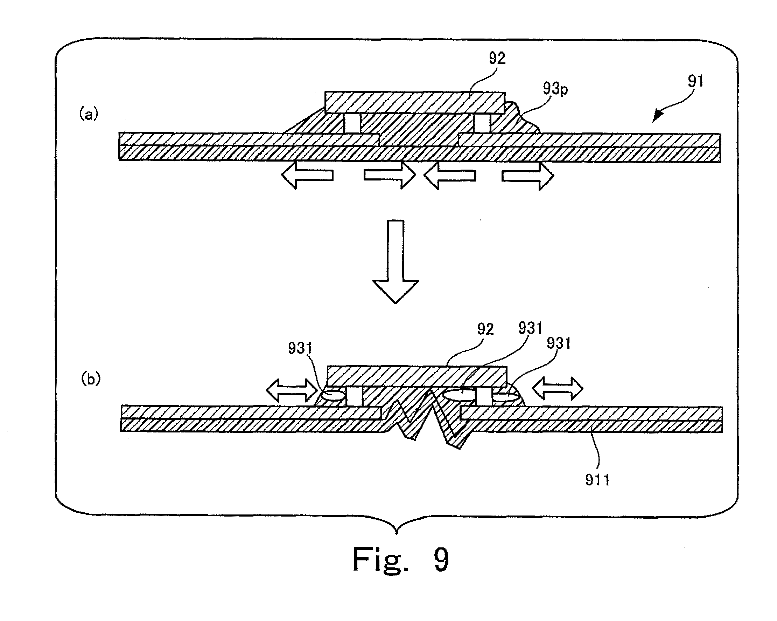

Fig. 9 is an explanatory diagram of a state of the base at the heating step of Part (d) of Fig. 8.

As illustrated in Part (a) of Fig. 9, when heat-treatment is performed in a state in which the IC chip 92 is mounted on the base 91, a temperature of the base 91 rises, causing the film 911 to deform as illustrated in Part (b) of Fig. 9. When the thermosetting adhesive 93p under curing flows due to deformation of the film 911, bubbles are generated in the thermosetting adhesive 93p to become and remain as voids 931 even after curing. Since the voids in the cured thermosetting adhesive 93p lower adhesive strength between the IC chip 92 and base 91, reliability of the RFID tag is lowered.

A problem of the reliability deterioration by generation of such voids is common to electronic apparatuses in each of which a circuit chip is mounted on a film-shaped base, besides the RFID tag.

### SUMMARY OF THE INVENTION

The present invention has been made in view of the above circumstances and provides a production method of an electronic apparatus whose reliability is improved by suppressing the generation of voids, a production method of electronic equipment in which this electronic apparatus is packaged, and a production method of an article in which this electronic apparatus is mounted.

The production method of an electronic apparatus of the present invention includes:
an adhesion step of making a thermosetting adhesive adhere to a face of a base in which a conductor pattern is formed on a film made of a resin material, the face being a face which the conductor pattern is formed on;
a mounting step of mounting a circuit chip connected to the conductor pattern, on the base via the thermosetting adhesive;
a preheating step of heating the thermosetting adhesive on a first heating condition by which the thermosetting adhesive becomes a first cured state; and
a main heating step of fixing the circuit chip to the conductor pattern by heating and curing the thermosetting adhesive on a second heating condition by which the thermosetting adhesive becomes a second cured state harder than the first cured state, with the base being clamped and pressurized from both of the circuit chip side and the film side.

In the production method of an electronic apparatus of the present invention, before heating and curing the thermosetting adhesive on the second heating condition becoming a second cured state at the main heating step, the thermosetting adhesive is heated at the preheating step on the first heating condition which is such a low temperature that deformation of the film is suppressed and thermosetting adhesive becomes comparatively soft in the first cured state. Since the thermosetting adhesive has already become a first cured state by the time of the main heating step, at the main heating step, flow of the thermosetting adhesive is suppressed when heating and curing the thermosetting adhesive, which avoids generation of voids. Therefore, reliability of the electronic apparatus is improved. In addition, since a manufacturing yield of the electronic apparatus is improved, a manufacturing cost becomes cheap.

Here, in the production method of an electronic apparatus of the above-mentioned present invention, it is preferable that the preheating step is a step of heating the thermosetting adhesive with the base being clamped and pressurized from both of the circuit chip side and film side.

Because, at the preheating step similarly to the main heating step, the thermosetting adhesive is heated such that the base is clamped and pressurized by the heater, the same kind of heating apparatus can be used at the main heating step and at the preheating step.

Here, in the production method of an electronic apparatus of the present invention, it is preferable that the main heating step is a step using the second heating condition as a temperature condition, and that the preheating step is a step using the first heating condition which is a lower than the temperature condition of the second heating condition, as a temperature condition.

Although a temperature and a time of heating are included in the heating condition, it is possible to control a cured state of the thermosetting adhesive without greatly changing the time at the main heating step and preheating step because the temperature condition of the first heating condition is made lower than the temperature condition of the second heating condition here. Hence, it is easy to perform the steps in a production line in parallel simultaneously.

Here, in the production method of an electronic apparatus of the present invention, it is preferable that the electronic apparatus is an RFID tag which makes the conductor pattern function as an antenna for communication, and which performs radio communication through this conductor pattern by the circuit chip.

An RFID tag used in a state of being installed in an article or a card is requested to have a thin film to meet the demand for miniaturization and flexibility. The production method of an electronic apparatus of the present invention is suitable for production of an RFID tag.

In addition, a production method of electronic equipment of the present invention includes:
an adhesion step of making a thermosetting adhesive adhere to a face of a base where a conductor pattern is formed on a film made of a resin material, the face being a face where the conductor pattern is formed;
a mounting step of mounting a circuit chip, connected to the conductor pattern, on the base through the thermosetting adhesive;
a preheating step of heating the thermosetting adhesive on a first heating condition by which the thermosetting adhesive becomes in a first cured state;
a main heating step of fixing the circuit chip to the conductor pattern by heating and curing the thermosetting adhesive on a second heating condition by which the thermosetting adhesive becomes in a second cured state harder than the first cured state, with the base being clamped and pressurized from both sides of the circuit chip and the film; and
a packaging step of packaging the base, in which the circuit chip is fixed to the conductor pattern, in an equipment main body which is driven on the basis of an operation of the circuit chip.

In order to enhance miniaturization of electronic equipment and a degree of freedom of arrangement in an equipment main body, an electronic apparatus to be mounted in the electronic equipment needs to be thin. In the production method of electronic equipment of the present invention, even when the apparatus mounted in electronic equipment is made into a low profile where the circuit chip is mounted on the base made of the film, through the thermosetting adhesive, generation of a void is suppressed when heating and curing the thermosetting adhesive. Hence, reliability of the electronic equipment is improved.

Here, in the electronic equipment of the present invention, it is preferable that the preheating step is a step of heating the thermosetting adhesive with the base being clamped and pressurized from both of the circuit chip side and film side.

In addition, in the electronic equipment of the present invention, it is preferable that the main heating step is a step using the second heating condition as a temperature condition, and that the preheating step is a step using the first temperature condition which is lower than the temperature condition of the second heating condition, as a temperature condition.

Furthermore, in the electronic equipment of the present invention, it is preferable that the conductor pattern functions as an antenna for communication, and that the circuit chip performs radio communication through the conductor pattern.

Moreover, a production method of an article in which the electronic apparatus is mounted of the present invention, includes:
an adhesion step of making a thermosetting adhesive adhere to a face of a base in which a conductor pattern is formed on a film made of a resin material, the face being a face which the conductor pattern is formed on;
a mounting step of mounting a circuit chip connected to the conductor pattern, on the base through the thermosetting adhesive;
a preheating step of heating the thermosetting adhesive on a first heating condition by which the thermosetting adhesive becomes a first cured state;
a main heating step of fixing the circuit chip to the conductor pattern by heating and curing the thermosetting adhesive on a second heating condition by which the thermosetting adhesive becomes a second cured state harder than the first cured state, with the base being clamped and pressurized from both of the circuit chip side and the film side;
a mounting step of mounting the electronic apparatus in which the circuit chip is fixed to the conductor pattern of the base, in an accepting article; and
a storage step of storing information representing an attribute of the accepting article, in the circuit chip.

For example, in an article in which an apparatuses such as an RFID tag is mounted, thinning of the apparatus is requested so as to maintain integrity between the article and electronic apparatus. In the production method of electronic equipment of the present invention, even when the apparatus to be packaged in an article is made into a low profile where the circuit chip is mounted on the base, which is made of the film, through the thermosetting adhesive, generation of a void is suppressed when heating and curing the thermosetting adhesive. Hence, reliability of the apparatus is improved.

Here, in the article of the present invention, it is preferable that the preheating step is a step of heating the thermosetting adhesive with the base being clamped and pressurized from both of the circuit chip side and film side.

In addition, in the article of the present invention, it is preferable that the main heating step is a step using the second heating condition as a temperature condition, and that the preheating step is a step using the first temperature condition which is lower than the temperature condition of the second heating condition, as a temperature condition.

Furthermore, in the article of the present invention, it is preferable that the conductor pattern functions as an antenna for communication, and that the circuit chip performs radio communication through the conductor pattern.

As described above, the present invention realizes a production method of an electronic apparatus whose reliability is improved by suppressing the generation of voids, a production method of electronic equipment in which the electronic apparatus is packaged, and a production method of an article in which the electronic apparatus is mounted.

### BRIEF DESCRIPTION OF THE DRAWINGS

Fig. 1 is a perspective view illustrating an RFID tag produced according to an embodiment of the present invention;
Fig. 2 is an explanatory diagram of a production method of the RFID tag illustrated in Fig. 1;
Fig. 3 is a diagram illustrating a production line which performs the production method of RFID tags, illustrated in Fig. 2, in a flow process;
Fig. 4 is an explanatory diagram of a production method of a second embodiment which produces the RFID tag illustrated in Fig. 1;
Fig. 5 is a diagram illustrating a production line which performs the production method of RFID tag illustrated in Fig. 4 in a flow process;
Fig. 6 is an explanatory diagram of a production method of clothes in which an RFID tag is mounted;
Fig. 7 illustrates a cellular phone in which a printed circuit board apparatus produced according to one embodiment of the present invention is packaged;
Fig. 8 is an explanatory diagram of a method of producing an RFID tag in a conventional technique; and
Fig. 9 is a diagram illustrating a state of the base at the heating step of Fig. 8.

### DETAILED DESCRIPTION OF THE INVENTION

Hereafter, embodiments of the present invention will be described with reference to the drawings.

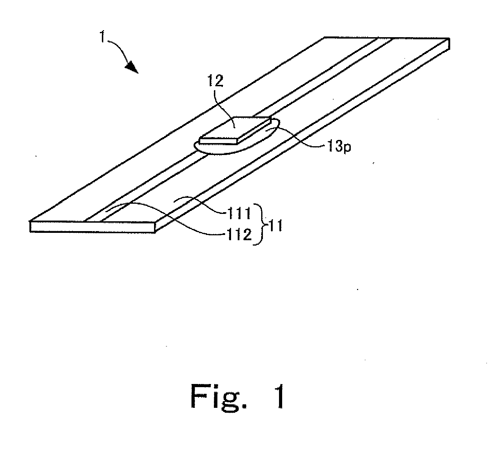

Fig. 1 is a perspective view illustrating an RFID tag produced according to an embodiment of the present invention.

An RFID tag 1 illustrated in Fig. 1 includes a base 11 in which a metal antenna pattern 112 is formed on a film 111 made of a PET material, an IC chip 12 mounted on the base 11, and a thermosetting adhesive 13p which bonds the base 11 and IC chip 12.

The RFID tag 1 of this embodiment is an electronic apparatus which contactlessly exchanges information with a reader writer, which is not illustrated, and receives energy of an electromagnetic field, which the reader writer emits, as electric energy by the antenna pattern 112. Then, the IC chip 12 is driven with the electric energy. The antenna pattern 112 functions as an antenna for communication, and the IC chip 12 executes radio communication through the antenna pattern 112.

Here, the RFID tag 1 is equivalent to an example of the electronic apparatus of the present invention, the antenna pattern 112 is equivalent to an example of the conductor pattern of the present invention, and the IC chip 12 is equivalent to an example of the circuit chip of the present invention.

In addition, among those skilled in the field of the present application, the "RFID tag" used in the specification of the present application may be called an "inlay for an RFID tag" which is an internal construction member (inlay) for the "RFID tag." Alternatively, this "RFID tag" may be called a "wireless IC tag." In addition, a noncontact IC card is also included in this "RFID tag."

Hereafter, a production method of this RFID tag 1 will be described.

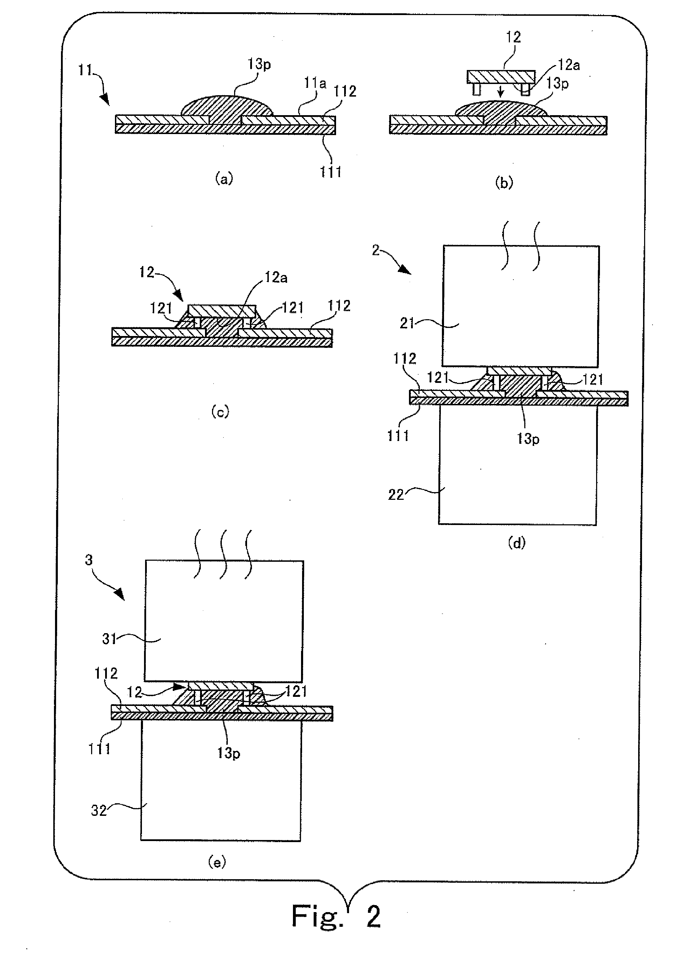

Fig. 2 is an explanatory diagram of the production method of the RFID tag illustrated in Fig. 1.

Fig. 2 illustrates each step of producing the RFID tag in order from Part (a) to Part (e). For the conspicuousness of a diagram, dimensions of the RFID tag 1 in a thickness direction and the IC chip 12 are exaggeratedly expressed in comparison with those illustrated in Fig. 1. In addition, in an actual production process, two or more RFID tags are formed side by side on one sheet of long film, and RFID tags are completed by separating the film into respective individual RFID tags. But, here, a production method will be described paying attention to one RFID tag.

For producing the RFID tag 1, first, at an adhesion step illustrated in Part (a) of Fig. 2, the base 11 in which the antenna pattern 112 is formed on the film 111 made of a PET material is prepared, and the liquid thermosetting adhesive 13p is made to adhere to this base 11. The thermosetting adhesive 13p is applied to an area for mounting the IC chip 12 and its vicinity on a mounting surface 11a which the antenna pattern 112 of the base 11 is formed on.

As the thermosetting adhesive 13p of this embodiment, for example, an epoxy adhesive is adopted, and in further detail, an anoxic-anhydrous epoxy adhesive whose curing rate, that is, a ratio of components to be cured is not less than 90% when being heated on curing conditions of 190°C and 8 sec is adopted. Nevertheless, as the thermosetting adhesive 13p, a resin material which has thermosetting property is adoptable besides the anoxic-anhydrous epoxy adhesive. The thermosetting adhesive 13p of this embodiment exerts practical strength when a curing rate is not less than 90%. Hereafter, the curing conditions of 190°C and 8 sec in the thermosetting adhesive 13p are called practical curing condition.

Next, the IC chip 12 is mounted on the portion of the base 11, to which the thermosetting adhesive 13p is adhered, at a mounting step illustrated in Part (b) and Part (c) of Fig. 2. The IC chip 12 is mounted on the base 11 by a flip chip assembly technique. That is, the IC chip 12 is mounted on the base 11 through the thermosetting adhesive 13p such that a face 12a of the IC chip 12, on which the circuit is formed, faces the base 11. Bumps 121 connected to the antenna pattern 112 are formed also on the face 12a. As illustrated in Part (c) of Fig. 2, the IC chip 12 is mounted on the base 11 in a state where the bumps 121 are aligned with the antenna pattern 112.

Subsequently, at a preheating step illustrated in Part (d) of Fig. 2, the base 11 on which the IC chip 12 is mounted is clamped and pressurized by a heating apparatus 2 from both of the film 111 side and the IC chip 12 side. The heating apparatus 2 has a heating head 21 as a hold-down section and a heating stage 22 as a supporting section, so that the base 11 is held between the heating head 21 and the heating stage 22. The heating head 21 embeds a heater which is not illustrated. At the preheating step, the heating head 21 abuts the 1C chip 12, and the heating stage 22 abuts the film 111. At the preheating step, the heating head 21 is made to generate heat and preheats the thermosetting adhesive 13p on the first heating condition. The first heating condition of this embodiment is set as a condition by which the thermosetting adhesive 13p starts a cure reaction, and has a curing rate of about 50% to become gel, that is, a semi hardened state. The first heating condition in this embodiment is 150°C and 8 sec, and is a lower temperature condition than the practical curing condition. In addition, on this first heating condition, the film 111 hardly deforms. Although the thermosetting adhesive 13p can be cured to the extent of having practical adhesive strength when it is applied for 30 sec even if a temperature is 150°C, a curing rate becomes about 50% by setting the time at 8 sec. To make the thermosetting adhesive 13p into a gel state where a curing rate is about 50% is also referred to as coming into a B stage. This gel state where the curing rate is about 50% is equivalent to an example of a first cured state in the present invention.

Next, at the main heating step illustrated in Part (e) of Fig. 2, the base 11 which is preheated is clamped and pressurized by a heating apparatus 3 from both of the film 111 side and the IC chip 12 side. Similarly to the heating apparatus 2, the heating apparatus 3 also has a heating head 31 as a hold-down section, and a heating stage 32 as a supporting section such that the base 11 is held between the heating head 31 and the heating stage 32, and the heating head 31 embeds a heater which is not illustrated. At the main heating step, the heating head 31 abuts on the IC chip 12, and the heating stage 32 abuts on the film 111. At the main heating step, the heating head 31 is made to generate heat and preheats the thermosetting adhesive 13p on a second heating condition. The second heating condition of this embodiment is set at a condition by which a curing rate of the thermosetting adhesive 13p becomes not less than 90%. The thermosetting adhesive 13p has the curing rate of not less than 90% by being heated on the second heating condition, and has practical adhesive strength. This state where the curing rate is about 90% is equivalent to an example of a second cured state in the present invention.

At the main heating step, because of heating the thermosetting adhesive 13p on the second heating condition equivalent to the practical curing condition, even if the preheating step is not performed, the thermosetting adhesive 13p is cured to a state of the curing rate being not less than 90%. However, the preheating step is performed in the production method of this embodiment, and a temperature condition which is lower than the temperature condition of the second heating condition, is used as the first temperature condition at the preheating step. For this reason, when performing heating at the main heating step, the thermosetting adhesive 13p is already gel. Thus, flow of the thermosetting adhesive 13p is suppressed when heating the thermosetting adhesive 13p at the main heating step, and generation of a void is suppressed.

The RFID tag 1 illustrated in Fig. 1 is obtained by cooling the base 11 with the circuit chip 12 mounted after the main heating step.

So far, the production process has been described paying attention to one RFID tag. From now on, the actual production process of arranging and forming two or more RFID tags on one sheet of long film by a flow process will be described.

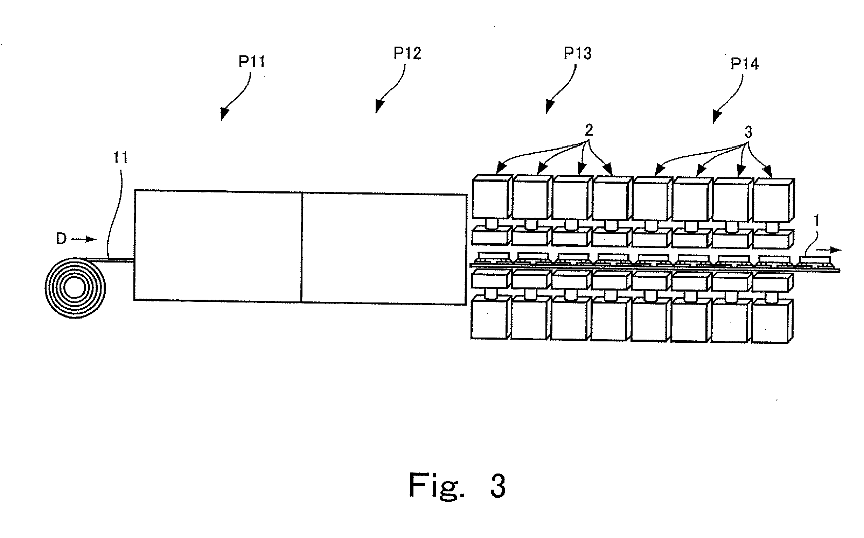

Fig. 3 is a diagram illustrating a production line which performs the production method of RFID tags, illustrated in Fig. 2, in a flow process. Fig. 3 illustrates roughly the production line which produces two or more RFID tags using the one sheet of long film-shaped base.

In the base 11, two or more antenna patterns 112 (refer to Fig. 2) corresponding to two or more RFID tags are located and formed in a line at predetermined intervals on the one sheet of long film 111 (refer to Fig. 2). Two or more RFID tags are produced by passing through an adhesion step P11, a mounting step P12, a preheating step P13, and a main heating step P14 in this order while a base 11 is conveyed in the conveying direction D. Each of the adhesion step P11, mounting step P12, preheating step P13, and actual heating step P14 performs processing for four RFID tags at once. Four heating apparatuses 2 and four heating apparatuses 3 are arranged at the preheating step P13 and actual heating step P14, respectively. Respective steps proceed in parallel simultaneously, and a period of performing processing at each step is called a processing cycle. Whenever one processing cycle is executed, the base 11 is conveyed in the conveying direction D by a portion corresponding to four RFID tags. RFID tags are produced successively by repeating the processing cycle.

First, the thermosetting adhesive 13p is applied to the base 11 at the adhesion step P11, as illustrated in Part (a) of Fig. 2. Next, the IC chip 12 is mounted on the portion of the base 11, which the thermosetting adhesive 13p is applied to, at the mounting step P12 as illustrated in Part (b) and Part (c) of Fig. 2. Subsequently, at the preheating step P13, while being clamped and pressurized by the heating apparatus 2, the base 11 is preheated on the first heating condition. In further detail, the heating apparatus 2 is heated to a temperature corresponding to the first heating condition, and the heating apparatus 2 clamps the base 11 for a time corresponding to the first heating condition. Subsequently, at the main heating step P14, while being clamped and pressurized by the heating apparatus 3, the base 11 is heated on the second heating condition. In further detail, the heating apparatus 3 is heated to a temperature corresponding to the second heating condition, and the heating apparatus 3 clamps the base 11 for a time corresponding to the second heating condition. The RFID tags 1 are obtained by cutting the base 11 separately after the main heating step P14.

Four heating apparatuses 2 arranged at the preheating step P13 and four heating apparatuses 3 arranged at the main heating step P14 are the same kind of heating apparatuses, but heating conditions, particularly, heating temperatures among heating conditions are different. In the production line illustrated in Fig. 3, it is possible to provide the preheating step P13 by making use of part of the arranged heating apparatuses. More particularly, eight heating apparatuses are arranged side by side, four of which are located in the upstream where the base 11 is conveyed and are set at the temperature of the first heating condition, and the remaining four of which are set at the temperature of the second heating condition.

In the embodiment mentioned above, the example of heating the base 11 so as to be clamped and pressurized by the heating apparatus 2 at the preheating step is described. Next, a second embodiment of the present invention where pressurization is not performed at the preheating step will be described. On the occasion of the following description of the second embodiment, the same reference numerals are assigned to the same components as respective components in the embodiment described up to now, and difference between the first and the second embodiments will be mainly described.

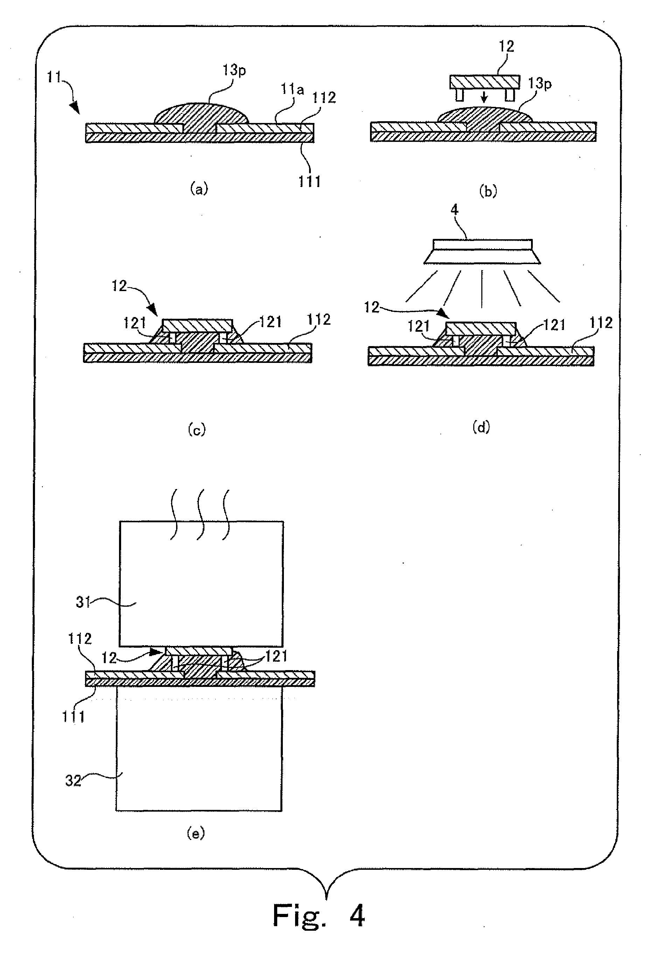

Fig. 4 is an explanatory diagram of a production method of the second embodiment which produces the RFID tag illustrated in Fig. 1.

Fig. 4 illustrates each step of producing the RFID tag 1 in order from Part (a) to Part (e). In the production method of the second embodiment, the preheating step illustrated in Part (d) of Fig. 4 is different from the preheating step in the first embodiment. At the preheating step illustrated in Part (d) of Fig. 4, the thermosetting adhesive 13p is heated by causing infrared irradiation equipment 4 to radiate infrared rays. The infrared irradiation equipment 4 radiates infrared rays having strength sufficient for heating the thermosetting adhesive 13p at a temperature of 150°C which is the first heating condition. Thereby, when performing heating at the main heating step illustrated in Part (e) of Fig. 4, the thermosetting adhesive 13p is already gel. In consequence, since flow of the thermosetting adhesive 13p is suppressed when heating the thermosetting adhesive 13p at the main heating step, generation of a void is suppressed.

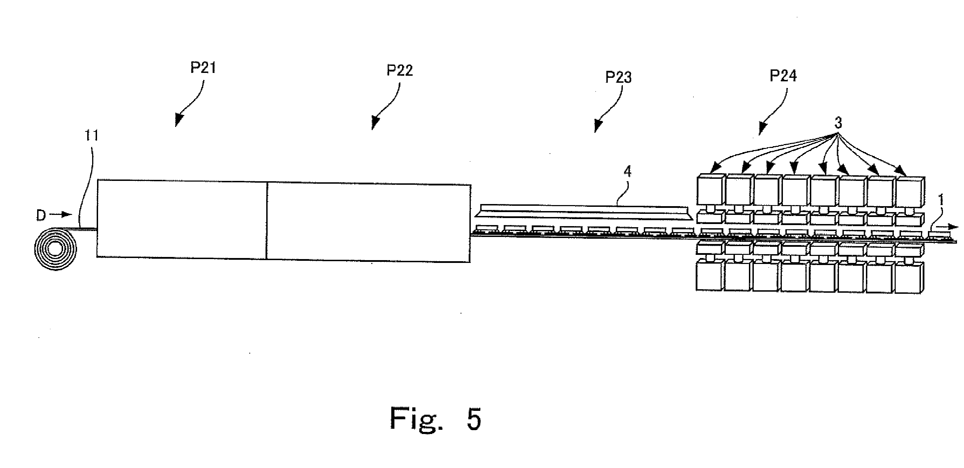

Fig. 5 is a diagram illustrating a production line which performs the production of RFID tags, illustrated in Fig. 4, in a flow process.

Fig. 5 illustrates roughly the production line which produces two or more RFID tags using one sheet of long film-shaped base.

In the production line illustrated in Fig. 5, an adhesion step P21, a mounting step P22, a preheating step P23, and a main heating step P24 are different from those in the production line illustrated in Fig. 3, respectively. In the production line illustrated in Fig. 5, a point of performing processing corresponding to eight RFID tags simultaneously and a point that eight heating apparatuses 3 are arranged at the main heating step P24, and infrared irradiation equipment 4 is arranged at the preheating step P23. In this production line, since the infrared irradiation equipment 4 performs processing at the preheating step, all of the eight heating apparatuses are arranged at the main heating step P24.

Next, as an application of the RFID tag 1 mentioned above, a production method of an article in which the RFID tag 1 is mounted will be described. The production method is one embodiment of the production method of an article in which an electronic apparatus is mounted according to the present invention.

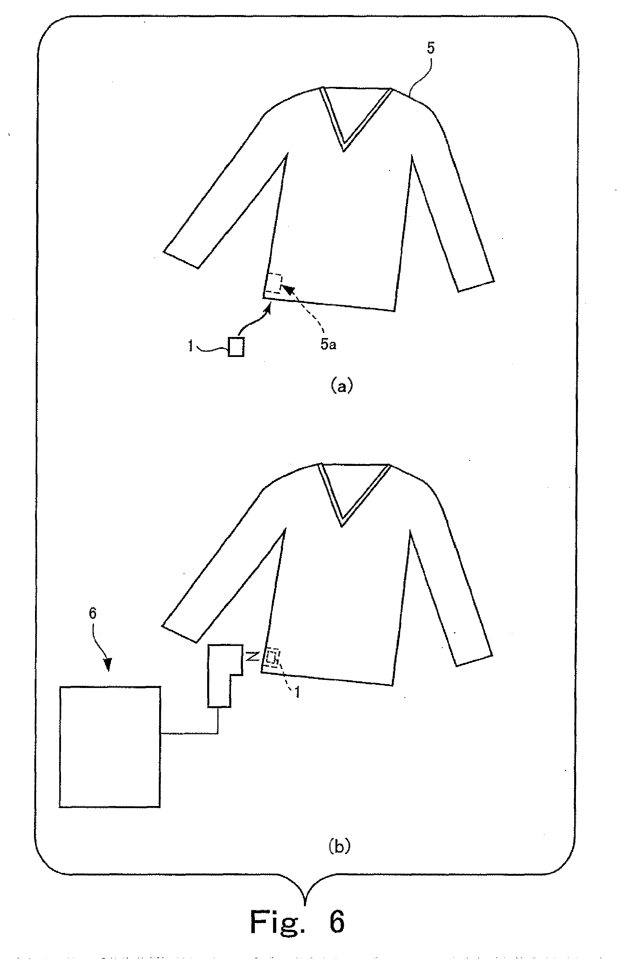

Fig. 6 is an explanatory diagram of a production method of clothes in which an RFID tag is mounted.

The RFID tag 1 produced by either of the production methods described in Fig. 2 to Fig. 5 is mounted by attachment and the like on a tag 5a of clothes 5 at a mounting step illustrated in Part (a) of Fig. 6.

Subsequently, information representing an attribute of the clothes 5 is stored in the RFID tag 1 mounted in the clothes 5 at a storage step illustrated in Part (b) of Fig. 6. For example, attribution information of the clothes 5, such as JAN code system, is transmitted to the RFID tag 1 via radio communication from an information writing apparatus 6, and the attribution information is stored in the circuit chip 12 (refer to Fig. 1).

Although the example of the RFID tag has been described in the embodiment mentioned above, it is possible to apply the production method of the RFID tag also to production of a printed circuit board apparatus which has a film-shaped base.

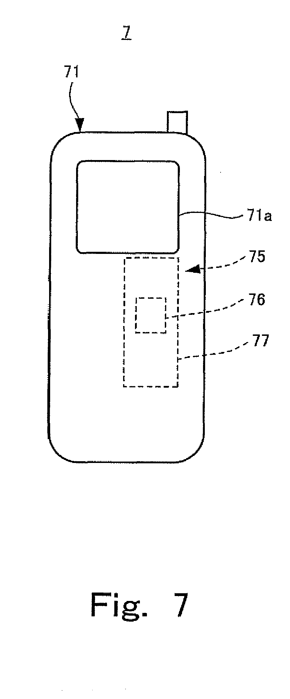

Fig. 7 illustrates a printed circuit board apparatus produced according to one embodiment of the present invention, and a cellular phone in which this printed circuit board apparatus is packaged.

The cellular phone 7 illustrated in Fig. 7 has a telephone body section 71, and a printed circuit board apparatus 75 packaged in the telephone body section 71. The printed circuit board apparatus 75 has a flexible printed circuit 77 (FPC 77) as a base, and a circuit chip 76 fixed to the FPC 77 with a thermosetting adhesive. The telephone body section 71 is provided with a display section 71a which is driven on the basis of an operation of the circuit chip 76, and shows various displays.

The printed circuit board apparatus 75 is produced by a method similar to the production methods of the RFID tag 1 illustrated in Fig. 2 to Fig. 5. That is, the printed circuit board apparatus 75 has a thin structure in which a circuit chip is mounted on a base made of a film, through a thermosetting adhesive, and is produced by passing through an adhesion step, a mounting step, a preheating step, and a main heating step in this order. The printed circuit board apparatus 75 is packaged in the telephone body section 71. The printed circuit board apparatus 75 has a thin form but is reliable, because it is produced by a method of suppressing the generation of a void.

In addition, although the method of producing an RFID tag and a printed circuit board apparatus is described in the embodiment mentioned above, the present invention is not limited to these. The present invention may be applied to a production method of an ultrathin IC card, and the like, for example, so long as it is a production method of an electronic apparatus in which a circuit chip is mounted on a film-shaped base.

Furthermore, although a film which constitutes a base of an RFID tag is described as that made of a PET material in the embodiments mentioned above, a film of an electronic apparatus of the present invention is not limited to this. A film may be formed of a material selected from a polyester material, a polyolefine material, a polycarbonate material, an acrylic material, and the like.

Moreover, in the embodiments mentioned above, a heating time for pressurizing the base 11 and a time for heating the thermosetting adhesive 13p by the heating apparatus 2 or 3 are the same, the preheating step and heating step of the present invention are not limited to this. For example, after pressurizing a base by a heating apparatus, the base may be heated.

## Claims

1. A production method of an electronic apparatus, comprising:
an adhesion step of making a thermosetting adhesive adhere to a face of a base in which a conductor pattern is formed on a film made of a resin material, the face being a face which the conductor pattern is formed on;
a mounting step of mounting a circuit chip connected to the conductor pattern, on the base via the thermosetting adhesive;
a preheating step of heating the thermosetting adhesive on a first heating condition by which the thermosetting adhesive becomes a first cured state; and
a main heating step of fixing the circuit chip to the conductor pattern by heating and curing the thermosetting adhesive on a second heating condition by which the thermosetting adhesive becomes a second cured state harder than the first cured state, with the base being clamped and pressurized from both of the circuit chip side and the film side.

2. The production method of an electronic apparatus according to claim 1, wherein the preheating step is a step of heating the thermosetting adhesive with the base being clamped and pressurized from both of the circuit chip side and the film side.

3. The production method of an electronic apparatus according to claim 1, wherein the main heating step is a step of using the second heating condition as a temperature condition, and the preheating step is a step of using the first heating condition which is lower than the temperature condition of the second heating condition, as a temperature condition.

4. The production method of an electronic apparatus according to claim 1, wherein the electronic apparatus is an RFID tag which performs radio communication through the conductor pattern by the circuit chip as well as operates the conductor pattern as an antenna for communication.

5. A production method of electronic equipment, comprising:
an adhesion step of making a thermosetting adhesive adhere to a face of a base in which a conductor pattern is formed on a film made of a resin material, the face being a face which the conductor pattern is formed on;
a mounting step of mounting a circuit chip connected to the conductor pattern, on the base through the thermosetting adhesive;
a preheating step of heating the thermosetting adhesive on a first heating condition by which the thermosetting adhesive becomes a first cured state;
a main heating step of fixing the circuit chip to the conductor pattern by heating and curing the thermosetting adhesive on a second heating condition by which the thermosetting adhesive becomes a second cured state harder than the first cured state, with the base being clamped and pressurized from both of the circuit chip side and the film side; and
a packaging step of packaging the base, in which the circuit chip is fixed to the conductor pattern, in an equipment main body which is driven on the basis of an operation of the circuit chip.

6. The production method of electronic equipment according to claim 5, wherein the preheating step is a step of heating the thermosetting adhesive with the base being clamped and pressurized from both of the circuit chip side and the film side.

7. The production method of electronic equipment according to claim 5, wherein the main heating step is a step of using the second heating condition as a temperature condition, and the preheating step is a step of using the first heating condition which is lower than the temperature condition of the second heating condition, as a temperature condition.

8. The production method of electronic equipment according to claim 5, wherein the conductor pattern functions as an antenna for communication, and the circuit chip performs radio communication through the conductor pattern.

9. A production method of an article in which an electronic apparatus is mounted, comprising:
an adhesion step of making a thermosetting adhesive adhere to a face of a base in which a conductor pattern is formed on a film made of a resin material, the face being a face which the conductor pattern is formed on;
a mounting step of mounting a circuit chip connected to the conductor pattern, on the base through the thermosetting adhesive;
a preheating step of heating the thermosetting adhesive on a first heating condition by which the thermosetting adhesive becomes a first cured state;
a main heating step of fixing the circuit chip to the conductor pattern by heating and curing the thermosetting adhesive on a second heating condition by which the thermosetting adhesive becomes a second cured state harder than the first cured state, with the base being clamped and pressurized from both of the circuit chip side and the film side;
a mounting step of mounting the electronic apparatus in which the circuit chip is fixed to the conductor pattern of the base, in an accepting article; and
a storage step of storing information representing an attribute of the accepting article, in the circuit chip.

10. The production method of an article according to claim 9, wherein the preheating step is a step of heating the thermosetting adhesive with the base being clamped and pressurized from both of the circuit chip side and the film side.

11. The production method of an article according to claim 9, wherein the main heating step is a step of using the second heating condition as a temperature condition, and the preheating step is a step of using the first heating condition which is lower than the temperature condition of the second heating condition, as a temperature condition.

12. The production method of an article according to claim 9, wherein the conductor pattern functions as an antenna for communication, and the circuit chip performs radio communication through the conductor pattern.
